# EUROPEAN PATENT SPECIFICATION

(11) **EP 3 823 045 B1**
(45) Date of publication and mention of the grant of the patent: **21.05.2025**
(21) Application number: 20206833.4
(22) Date of filing: 11.11.2020
(51) Int. Cl.: H10D 8/60, H10D 30/63, H10D 30/66, H10D 62/80, H01L 21/34, H01L 21/467, H01L 21/02, H10D 62/10, H10D 64/00

(54) **SEMICONDUCTOR DEVICE AND SYSTEM INCLUDING SEMICONDUCTOR**
HALBLEITERBAUELEMENT UND SYSTEM MIT HALBLEITER
DISPOSITIF SEMI-CONDUCTEUR ET SYSTÈME COMPRENANT UN SEMI-CONDUCTEUR

(30) Priority: 14.11.2019 JP 2019206570; 21.10.2020 JP 2020176965
(43) Date of publication of application: 19.05.2021
(73) Proprietor: Flosfia Inc., Kyoto 615-8245 (JP)
(72) Inventor: Amazutsumi, Koji, Kyoto, 615-8245 (JP); Norimatsu, Kazuyoshi, Kyoto, 615-8245 (JP); Okigawa, Mitsuru, Kyoto, 615-8245 (JP)
(74) Representative: Gulde & Partner

(56) References cited:
- EP-A1- 3 190 608
- EP-A1- 3 690 924
- WO-A1-2018/159350
- WO-A1-2019/065751
- US-A1- 2019 140 092
- JIAN ZHE (ASHLEY) ET AL: "Chlorine-based inductive coupled plasma etching of [alpha] -Ga 2 O 3", SEMICONDUCTOR SCIENCE AND TECHNOLOGY., vol. 34, no. 3, 31 January 2019 (2019-01-31), GB, pages 035006, XP055788388, ISSN: 0268-1242, Retrieved from the Internet <URL:http://iopscience.iop.org/article/10.1088/1361-6641/aafeb2> DOI: 10.1088/1361-6641/aafeb2
- ZHANG HONGPENG ET AL: "Progress of Ultra-Wide Bandgap Ga2O3 Semiconductor Materials in Power MOSFETs", IEEE TRANSACTIONS ON POWER ELECTRONICS, INSTITUTE OF ELECTRICAL AND ELECTRONICS ENGINEERS, USA, vol. 35, no. 5, 9 October 2019 (2019-10-09), pages 5157 - 5179, XP011774711, ISSN: 0885-8993, [retrieved on 20200226], DOI: 10.1109/TPEL.2019.2946367
- LI WENSHEN ET AL: "2.44 kV Ga2O3 vertical trench Schottky barrier diodes with very low reverse leakage current", 2018 IEEE INTERNATIONAL ELECTRON DEVICES MEETING (IEDM), IEEE, 1 December 2018 (2018-12-01), XP033501015, DOI: 10.1109/IEDM.2018.8614693

## Description

### BACKGROUOND OF THE INVENTION

### Field of the Invention

The present inventive subject matter relates to semiconductor devices, for example, such as power devices. The present inventive subject matter also relates to semiconductor systems including the semiconductor device(s).

### Description of the Related Art

Gallium oxide is drawing attention as a next-generation semiconductor material. Gallium oxide is expected as a material capable of realizing a high breakdown voltage large current semiconductor device and has a large band gap, and have been studied variously, for a purpose of increasing a reverse breakdown voltage and further reducing an initial forward voltage, etc.

In recent years, semiconductor devices including trench(es) have been studied. As semiconductor devices of β-Ga₂O₃ having trenches, for example, semiconductor devices described in Patent Documents 1 to 3 are disclosed. Also, as semiconductor devices of α-Ga₂O₃ having trenches, for example, semiconductor devices described in Patent Documents 4, 5, 6 and 7 are disclosed. Further semiconductor devices, materials and methods are described in the non-patent literature documents 1, 2 and 3.

However, when a trench(es) is formed in a crystalline oxide semiconductor such as a gallium oxide, that has different etching characteristics from other semiconductor material(s), and thus, it has been difficult to form the trench(es) having an arc portion adjacent to the bottom of the trench, the arc portion with a radius of curvature that is in a rage of 100 nm or more, which is able to expect electric-field relaxation. For example, when a crystalline gallium oxide was forcibly etched with conditions of dry etching, a bottom of a trench became rough, and the width inside the trench became wider than the width at the opening of the trench. As a result, electric-field relaxation effect was not sufficiently exhibited and there has been a problem that the on-resistance was increased.

### [Citation List]

### [Patent Literature]

PTL1: JP2019-036593
PTL2: JP2019-079984
PTL3: JP2019-153645
PTL4: WO2016/013554
PTL5: WO2019/013136
PTL6: WO 2019/065751 A1
PTL7 : EP 3 190 608 A1

### [Non-Patent Literature]

NPTL1: JIAN ZHE (ASHLEY) ET AL: "Chlorine-based inductive coupled plasma etching of α-Ga2O3", SEMICONDUCTOR SCIENCE AND TECHNOLOGY, vol. 34, no. 3, (2019), p. 035006,
NPTL2: ZHANG HONG PENG ET AL: "Progress of Ultra-Wide Bandgap Ga2O3 Semiconductor Materials in Power MOSFETs", IEEE TRANSACTIONS ON POWER ELECTRONICS, INSTITUTE OF ELECTRICAL AND ELECTRONICS ENGINEERS, USA, vol. 35, no. 5, (2019), p. 5157-5179,
NPTL3: LI WENSHEN ET AL: "2.44 kV Ga2O3 vertical trench Schottky barrier diodes with very low reverse leakage current", 2018 IEEE INTERNATIONAL ELECTRON DEVICES MEETING (IEDM), IEEE, (2018)

### SUMMARY OF THE INVENTION

In a first aspect of a present inventive subject matter, a semiconductor device includes a crystalline oxide semiconductor layer, and at least one electrode electrically connected to the crystalline oxide semiconductor layer. The crystalline oxide semiconductor layer consists of α-Ga₂O₃. The crystalline oxide semiconductor layer includes at least one trench in the crystalline oxide semiconductor layer at a side of a first surface of the crystalline oxide semiconductor layer. The trench includes a bottom, a side, and at least one arc portion positioned between the bottom and the side with a radius of curvature that is in a range of 100 nm to 500 nm, and the trench has a width that is 2 µm or less. An angle between the side of the trench and the first surface of the crystalline oxide semiconductor layer is 90° or more.

In an embodiment of a semiconductor device, the angle between the side of the trench and the first surface of the crystalline oxide semiconductor layer is 150° or less.

Also, according to an embodiment of a semiconductor device, the trench has a width that becomes narrower toward the bottom of the trench. The side of the trench may be tapered.

In an embodiment of a semiconductor device, the angle between the side of the trench and the first surface of the crystalline oxide semiconductor layer is in a range of greater than 90° to 135° or less.

In a further embodiment, the semiconductor device includes a first electrode electrically connected to the crystalline oxide semiconductor layer; and a second electrode electrically connected to the crystalline oxide semiconductor layer.

According to an embodiment of a semiconductor device, the first electrode is positioned closer to the first surface of the crystalline oxide semiconductor layer than the second electrode, and the second electrode is positioned closer to a second surface of the crystalline oxide semiconductor layer than the first electrode. The second surface of the crystalline oxide semiconductor layer is positioned opposite to the first surface of the crystalline oxide semiconductor layer.

Also, according to an embodiment of a semiconductor device, the semiconductor device is a vertical semiconductor device.

In an embodiment of a semiconductor device, the semiconductor device includes a barrier height adjustment region arranged in the at least one trench in the crystalline oxide semiconductor layer.

Also, according to an embodiment of a semiconductor device, the at least one trench includes two or more trenches, and the barrier height adjustment region includes two or more barrier height adjustment regions each arranged in one of the two or more trenches. The two or more barrier height adjustment regions may be connected to one another.

### BRIEF DESCRIPTION OF THE DRAWING

Fig. 1 is a schematic diagram showing an embodiment of a Junction Barrier Schottky Diode (JBS) as an example of an embodiment of a semiconductor device according to the present inventive subject matter.
Fig. 2 is an explanatory drawing for explaining a radius of curvature of an arc portion in an embodiment of the present inventive subject matter.
FIG. 3 shows a schematic view of a power system as an example.
FIG. 4 shows a schematic view of a system device as an example.
FIG. 5 shows a schematic view of a power source circuit of a power source device as an example.
FIG. 6 shows a schematic diagram of a film (layer)-formation apparatus (a mist CVD apparatus) used in Practical Examples of the present inventive subject matter.
FIG. 7 is a picture of a cross section of a trench in Practical Example 1.
FIG. 8 is a picture of a cross section of a trench in Practical Example 2.
FIG. 9 is a schematic diagram showing an embodiment of a Schottky barrier diode (SBD) as an example of an embodiment of a semiconductor device according to the present inventive subject matter.
FIG. 10 is a schematic diagram showing an aspect of a trench-MOS Schottky Barrier Diode (SBD) as an example of an embodiment of a semiconductor device according to the present inventive subject matter.
FIG. 11 is a schematic diagram showing an aspect of a Junction Barrier Schottky Diode (JBS) as an example of an embodiment of a semiconductor device according to the present inventive subject matter.
FIG. 12 shows a schematic view of an aspect of a MOSFET as an example of an embodiment of a semiconductor device according to the present inventive subject matter.
FIG. 13 shows a schematic view of an aspect of a MOSFET as an example of embodiment of a semiconductor device according to the present inventive subject matter.
FIG. 14 is an explanatory view of an angle formed by the side of the trench and the first surface of the crystalline oxide semiconductor layer.
FIG. 15 is an explanatory view of a taper angle in an embodiment according to the present inventive subject matter, wherein the side of the trench is tapered.
FIG. 16-a is a picture of a cross section of a trench in Practical Example 3.

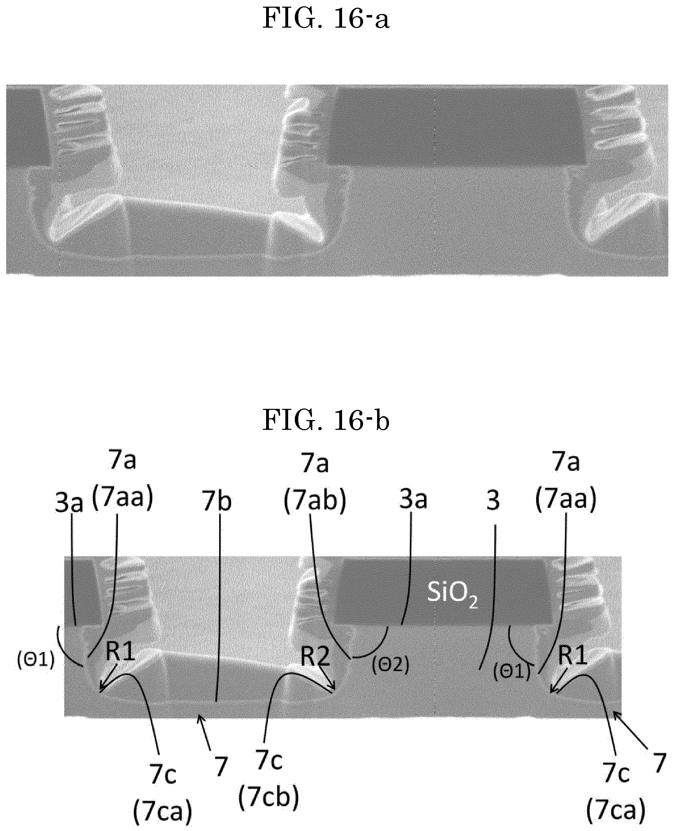

FIG. 16-b is an explanatory picture of the cross section of the trench in Practical Example 3.

### DETAILED DESCRIPTION OF EMBODIMENTS

The terminology used herein is for the purpose of describing particular embodiments only and is not intended to be limiting of the subject matter. As used herein, the term "and/or" includes any and all combinations of one or more of the associated listed items.

As illustrated in the figures submitted herewith, some sizes of structures or portions may be exaggerated relative to other structures or portions for illustrative purposes. Relative terms such as "below" or "above" or "upper" or "lower" may be used herein to describe a relationship of one element, layer or region to another element, layer or region as illustrated in the figures. It will be understood that these terms are intended to encompass different orientations of a layer, a device, and/or a system in addition to the orientation depicted in the figures.

As an object of a semiconductor device according to a present inventive subject matter, a semiconductor device including a α-Ga₂O₃ crystalline oxide semiconductor film including trench(es) with an enhanced semiconductor property. The present inventors have intensively studied in order to achieve the above object, and as a result, by forming trench(es) in the crystalline oxide semiconductor layer by a high-pressure dry etching with specific conditions, succeeded in obtaining a semiconductor device including the crystalline oxide semiconductor layer that includes at least a trench in the crystalline oxide semiconductor layer. The trench includes a bottom, a side, and at least one arc portion with a radius of curvature that is in a range of 100 nm to 500 nm. The at least one arc portion is positioned between the bottom and the side, and an angle between the side of the trench and the first surface of the crystalline oxide semiconductor layer is 90° or more. With such a configuration of the crystalline oxide semiconductor layer, the semiconductor device is able to have an enhanced semiconductor property.

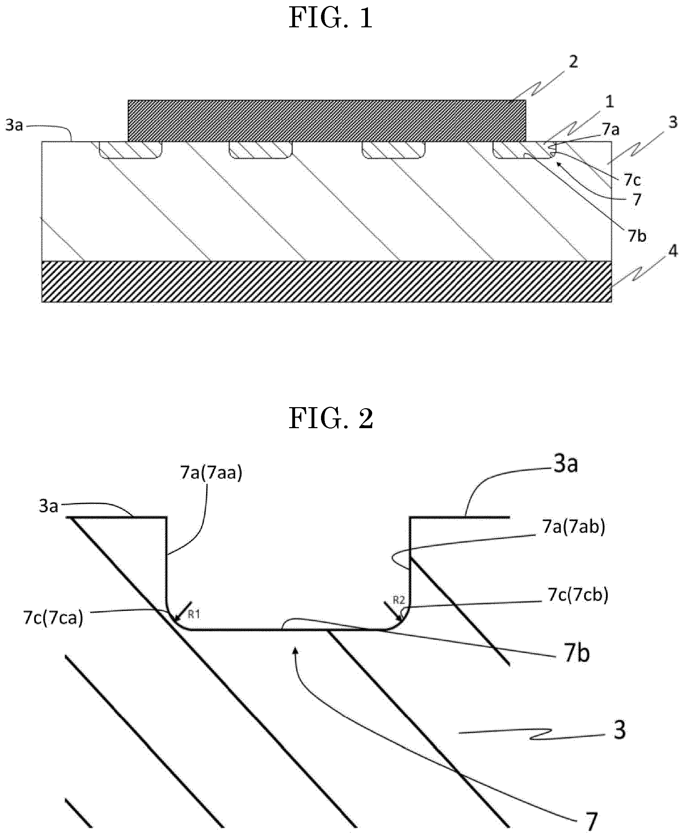

The term "radius of curvature" means, in a cross section of the trench, a radius of an osculating circle that corresponds to a curve of the arc portion. The term "arc portion" may refer to a part of a perfect circle, also may refer to a part of an ellipse shape, and only requires to have an arc shape as a whole, and may be refer to a part of a polygon with rounded corners. That is, the arc portion, in the cross section of the trench, is just required to be have a curving shape and also provided at least one part between the side and the bottom of the trench. For example, an example of an arc portion is shown in FIG 2. The crystalline oxide semiconductor shown in FIG. 2 includes two arc portions 7c with a radius of curvature at R1 and a radius of curvature at R2 that are in a range of 100 nm to 500 nm in FIG. 2. With the range of such a radius of curvature, it is possible to realize an excellent electric field relaxation effect, and that results in reducing the on-resistance. Further, in an embodiment of the present inventive subject matter, the trench may include an arc portion entirely arranged between the bottom 7b and the side 7a of the trench 7. Also, in an embodiment of the present inventive subject matter, the trench 7 includes a first arc portion 7c (7ca) and a second arc portion 7c (7cb). The first arc portion 7ca has a radius of curvature R1 and is positioned between the bottom 7b and a first side 7a (7aa) of the trench 7, a second arc portion 7cb has a radius of curvature R2 and is positioned between the bottom 7b and a second side 7a (7ab) of the trench 7, and difference between the radius of curvature R1 of the first arc portion 7ca and the radius of curvature R2 of the second arc portion 7cb is preferably in a range of 0 nm to 200 nm, and further preferably in a range of 0 to 50 nm. In an embodiment of the present inventive subject matter, the radius of curvature R1 of the first arc portion 7ca is most preferably equivalent to the radius of curvature R2 of the second arc portion 7cb.

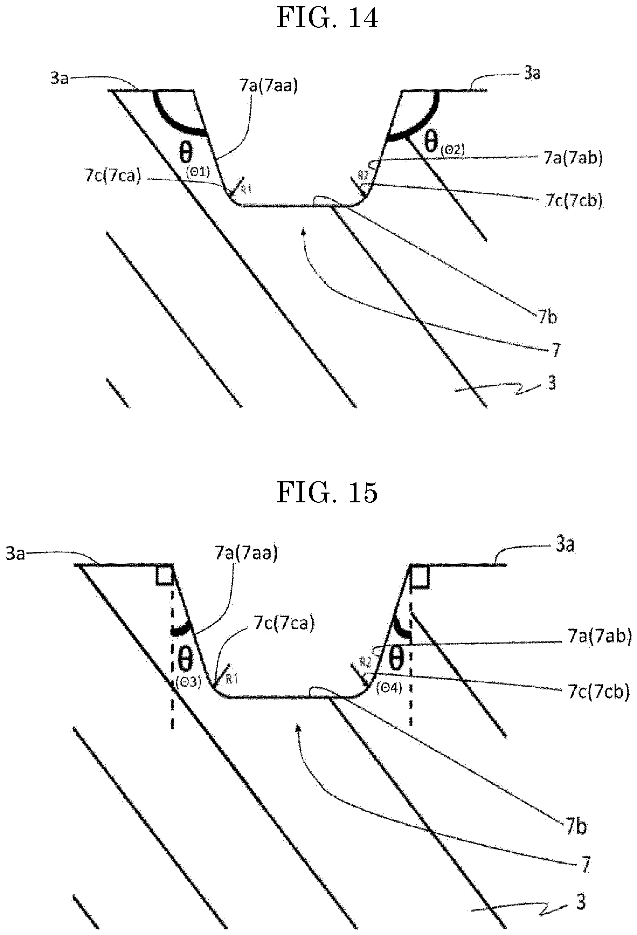

"An angle between a side and a first surface of a crystalline oxide semiconductor layer" herein refers to, in a cross section of the trench 7, the angle between the side of the trench, that is arranged in the crystalline oxide semiconductor layer at a side of a first surface 3a of the crystalline oxide semiconductor layer 3, and the first surface 3a of the crystalline oxide semiconductor layer, is according to the present inventive subject matter, 90 ° or more. As such "the angle between the side of the trench and the first surface of the crystalline oxide semiconductor layer", an angle represented by θ shown in FIG. 14 (also, an angle represented by θ1, θ2 shown in FIG. 16-b) is illustrated as example(s). In the present inventive subject matter, with the angle θ1 between the first side 7aa of the trench 7 and the first surface 3a of the crystalline oxide semiconductor layer 3 and the angle θ2 between the second side 7ab of the trench 7 and the first surface 3a of the crystalline oxide semiconductor layer 3, it is possible to realize an enhanced electric field relaxation effect, and as a result, it is also possible to reduce the on-resistance. Further, the upper limit of "the angle between the side of the trench and the first surface of the crystalline oxide semiconductor layer" is not particularly limited, as long as an object of the present inventive subject matter is not interfered with, however, preferably is 150 °. Also, in an embodiment of the present inventive subject matter, in the cross section of the trench, the angle θ1 between the first side 7aa of the trench 7 and the first surface 3a of the crystalline oxide semiconductor layer 3 is preferably equivalent to the angle θ2 between the second side 7ab of the trench 7 and the first surface 3a of the crystalline oxide semiconductor layer 3.

The trench is formed into the crystalline oxide semiconductor layer, and is not particularly limited as long as the object of the present inventive subject matter is not interfered with. The depth of the trench is not particularly limited, however, according to the present inventive subject matter, the depth of the trench in the cross section of the trench is usually 200 nm or more, preferably 500 nm or more, and further preferably 1 µm or more. The upper limit of depth of the trench is not particularly limited, however, preferably 100 µm, and further preferably 10 µm. According to the invention, the width of the trench in the cross section of the trench is 2 µm or less. With trench(es) in such a range of size, semiconductor devices such as power devices are able to exhibit an enhanced semiconductor property. Also, as an embodiment of the present inventive subject matter, in the trench-cross section, the trench has a width that becomes narrower toward the bottom of the trench as a preferable example, and with such a preferable structure, an interface (for example, an interface of the crystalline oxide layer and a layer and/or a region arranged in the trench) is able to be formed in good conditions, and thus, results in obtaining a good semiconductor property. Furthermore, it is also preferable that the side of the trench is tapered and the side of the trench has a tapered angle to the first surface of the crystalline oxide semiconductor layer. Also, the tapered angle refers to, in the trench-cross section, based on a virtual plane (without being tapered and thus, with the taper angle 0°) that is perpendicular to the first surface of the crystalline oxide semiconductor layer, an angle between the virtual plane and the side of the trench (that is tapered). As an example of a tapered angle, the angle indicated as θ (θ3, θ4) in FIG. 15 is referred to. According to embodiments of the present inventive subject matter, the taper angle is preferably greater than 0° and 45° or less. That is, the angle (for example, an angle shown as θ1, θ2 shown in FIG. 14 and FIG. 16-b) between the side of the trench and the first surface of the crystalline oxide semiconductor layer is in a range of greater than 90° to 135° or less. With such a preferable taper angle, a channel is to be formed in good condition and as a result, on-resistance is able to be further decreased.

Further, the electrode(s) may be a known one, for example, may be any of a Schottky electrode, an ohmic electrode, a gate electrode, a drain electrode and a source electrode or the like. The electrode(s) may be properly set according to a type of semiconductor device, and as electrode material(s), for example, d-block metal(s) in the periodic table may be named. Also, the electrode may be an electrode called as a barrier electrode. The barrier electrode is not particularly limited as long as the barrier electrode is able to form a barrier height between the semiconductor region and the barrier electrode. Electrode material(s) is not particularly limited as long as the electrode material(s) is used as a barrier electrode and may be an electrically-conductive inorganic material or an electrically-conductive organic material. According to embodiments of the present inventive subject matter, it is preferable that the electrode material(s) is a metal(s). The metal(s) is not particularly limited, and examples of the metal(s) include at least one metal selected from metals of Groups 4 to 11 of the periodic table. As metals of Group 4 in the periodic table, for example, titanium (Ti), zirconium (Zr), and hafnium (Hf) are named, and among them, Ti is preferable. As metals of Group 5 in the periodic table, for example, vanadium (V), niobium (Nb), and tantalum (Ta) are named. As metals of Group 6 in the periodic table, for example, one or two or more metals may be selected from chromium (Cr), molybdenum (Mo) and tungsten (W), and according to an embodiment of the present inventive subject matter, Cr is preferable because a switching property becomes better. As metals of Group 7 in the periodic table, for example, manganese (Mn), technetium (Tc), and rhenium (Re) are named. As metals of Group 8 in the periodic table, for example, include iron (Fe), ruthenium (Ru), and osmium (Os) are named. As metals of Group 9 in the Periodic Table, for example, cobalt (Co), rhodium (Rh), and iridium (Ir) are named. As metals of Group 10 in the periodic table, for example, nickel (Ni), palladium (Pd), and platinum (Pt) are named, and among them, Pt is preferable. As metals of Group 11 in the periodic table, for example, copper (Cu), silver (Ag), and gold (Au) may be named. As a method of forming a barrier electrode, for example, a known method may be named, for more specifically, such as a dry method and a wet method. The dry method, for example, such as a spattering method, vacuum deposition, or CVD may be named as a known method. The wet method such as screen printing or die coating may be named as a known method.

The crystalline oxide semiconductor layer according to the present inventive subject matter consists of α-Ga₂O₃. The crystalline oxide semiconductor layer (or may be just mentioned as "semiconductor region" as follows), preferably is an n-type semiconductor region containing an n-type semiconductor as a major component. The crystalline oxide semiconductor has a corundum structure. Also, in embodiments not forming part of the claimed invention, the semiconductor region comprises a mixed crystal of α-Ga₂O₃ as a major component. Also, the term "major component" means that, for example, when the crystalline oxide semiconductor is α-Ga₂O₃, α-Ga₂O₃ is contained in the semiconductor region such that the atomic ratio of gallium to entire metal elements in the film becomes at a rate of 0.5 or more. In embodiments of the present subject matter, the atomic ratio of gallium to the entire metal elements in the film is preferably 0.7 or more, and more preferably 0.8 or more. Also, the semiconductor region is usually a single-phase region, however, may further contain a second semiconductor region of a different semiconductor phase. Also, the semiconductor region usually has a shape of a film, and may be a semiconductor film. In addition, the thickness of the crystalline oxide semiconductor film is not particularly limited, and may be 1 µm or less, or may be 1 µm or more. According to an embodiment of the present subject matter, the thickness of the crystalline oxide semiconductor film is preferably 1 µm to 40 µm, further preferably 1 µm to 25 µm. Withstand voltage of a crystalline oxide semiconductor layer is increased, for example, by increasing the crystalline oxide semiconductor layer in thickness and/or lowering carrier concentration of the crystalline oxide semiconductor layer. On the other hand, as a trade-off of increasing the crystalline oxide semiconductor layer in thickness and/or lowering carrier concentration of the crystalline oxide semiconductor layer, there is a problem that on-resistance increases. Accordingly, in the present inventive subject matter, the gallium oxide-based crystalline oxide semiconductor layer consisting of α-Ga₂O₃ includes a trench(es) having an arc portion with a radius of curvature that is in a range of 100 nm to 500 nm, the arc portion is positioned between the side and the bottom of the trench, and an angle between the side of the trench and the first surface of the crystalline oxide semiconductor layer is greater than 90° to preferably 135° or less, electric field relaxation effect is sufficiently obtainable. According to the present inventive subject matter, it is possible to obtain sufficient electric field relaxation effect, it is possible to decrease the gallium oxide-based crystalline oxide layer (that includes a drift region) in thickness (for example, 10 µm or less), and with such a thickness, a semiconductor device having a high withstand voltage (for example, 3000 V or higher) is able to be realized. Also, according to an embodiment of the present inventive subject matter, carrier concentration of the gallium oxide-based crystalline oxide semiconductor layer (that includes a drift region) is able to be 5.0×10¹⁶/cm³ or higher, and preferably 3.0×10¹⁷/cm³ or higher. The thickness of the crystalline oxide semiconductor layer and the carrier concentration is able to be adjusted depending to a required withstand voltage, however, as mentioned above, even with a thinner thickness of the crystalline oxide semiconductor layer and higher carrier concentration than the thickness and carrier concentration of a conventional crystalline oxide semiconductor layer, it is possible to realize a semiconductor device with a higher withstand voltage than the conventional semiconductor device, and as a result, on-resistance is able to be decreased. The surface area of the semiconductor film is not particularly limited, and may be 1 mm² or more or may be 1 mm² or less. Further, the crystalline oxide semiconductor is usually a single crystal, however, may be a polycrystal. Also, the semiconductor film may be a single-layer film and also may be a multi-layer film. when the semiconductor film is a multi-layer film, the thickness of the multi-layer film is preferably 40 µm or less and the multi-layer film includes at least a first semiconductor layer and a second semiconductor layer. If a Schottky electrode is arranged on the first semiconductor layer, the multi-layer film is also preferable wherein the first semiconductor layer has a carrier concentration that is less than a carrier concentration the second semiconductor layer has. In this case, the second semiconductor layer, usually, contains a dopant, and the carrier concentration of the semiconductor layer (including the first semiconductor layer and the second semiconductor layer) is able to be properly set by adjusting a doping quantity.

The oxide semiconductor film preferably contains a dopant. The dopant is not particularly limited and may be a known dopant. The dopant may be an n-type dopant such as tin (Sn), germanium (Ge), silicon (Si), titanium (Ti), zirconium (Zr), vanadium (V), and niobium (Nb) or a p-type dopant. According to the present inventive subject matter, the dopant is preferably Sn, Ge or Si. The contained amount of dopant in the semiconductor film is preferably 0.00001 atomic percent (at.%) or more, and is more preferably in a range of 0.00001 at.% to 20 at.%, and most preferably in a range of 0.00001 at.% to 10 at.%. Also, according to an embodiment of the present inventive subject matter, it is preferable that a dopant contained in a first semiconductor layer is germanium, silicon, titanium, zirconium, vanadium or niobium, and a dopant contained in a second semiconductor layer is tin, because semiconductor property is further enhanced without impairing adhesiveness.

The semiconductor film is, for example, able to be formed by a method such as a mist CVD method, and more specifically, formed by generating atomized droplets by atomizing a raw-material solution (forming atomized droplets), carrying the atomized droplets (containing mist) with a carrier gas onto a base (carrying the atomized droplets), forming a semiconductor film containing a crystalline oxide semiconductor as a major component by the atomized droplets being thermally reacted in the film-formation chamber.

### (Forming atomized droplets)

In forming atomized droplets, a method of atomizing a raw-material solution, in that the raw-material solution is atomized to generate atomized droplets to be floating, is not particularly limited as long as the raw-material solution is able to be atomized, and may be a known method, however, in embodiments according to the present inventive subject matter, a method of forming atomized droplets using ultrasonic waves is preferable. Atomized droplets obtained by using ultrasonic waves are floating and have the initial velocity that is zero, and thus, preferable. Since atomized droplets floating in the space are carriable as gas, the atomized droplets that are floating without being blown like a spray, and thus, are preferable to avoid damage caused by the collision energy. The size of droplets is not particularly limited, and may be a few mm, however, preferably 50 µm or less, and further preferably 0.1 µm to 10 µm.

### (Raw-material solution)

The raw-material solution is not particularly limited as long as the raw-material solution is able to be atomized and contains raw material(s) that is able to form a semiconductor region. The raw material solution may contain an inorganic material and may contain an organic material, however, the raw material(s) may be preferably a metal(s) and/or a metal compound(s) and further preferably contains, in addition to gallium (Ga), one or two or more metals selected from iron (Fe), Iridium (Ir), indium (In), aluminum (Al), vanadium (V), titanium (Ti), chromium (Cr), rhodium (Rh), nickel (Ni), cobalt (Co), zinc (Zn), magnesium (Mg), calcium (Ca), silicon (Si), yttrium (Y), strontium (Sr), and barium (Ba).

In the present inventive subject matter, as the raw-material solution, in which the metal(s) in the form of a complex or a salt is dissolved or dispersed in an organic solvent or water can be suitably used. Examples of the form of the complex include an acetylacetonate complex, a carbonyl complex, an ammine complex, and a hydride complex. Examples of the form of the salt include organometallic salts (e.g., metal acetate, metal oxalate, metal citrate, etc.), metal sulfide salts, nitrified metal salts, phosphorylated metal salts, metal halide salts (e.g., metal chloride salts, metal bromide salts, metal iodide salts, etc.), and the like.

To the raw-material solution, an additive such as hydrohalic acid and an oxidant or the like is preferably mixed. Examples of the hydrohalic acid include hydrobromic acid, hydrochloric acid, and hydroiodic acid or the like, however, among them hydrobromic acid or hydroiodic acid is preferable because films are able to be obtained in better quality. Examples of the oxidant include: peroxides, such as hydrogen peroxide (H₂O₂), sodium peroxide (Na₂O₂), barium peroxide (BaO₂), and benzoyl peroxide (C₆H₅CO)₂O₂; hypochlorous acid (HClO); perchloric acid; nitric acid; ozone water; organic peroxides, such as peracetic acid and nitrobenzene.

The raw-material solution may contain a dopant. It is possible to perform doping in good conditions if the dopant is contained in the raw-material solution. The dopant is not particularly limited as long as an object of the present inventive subject matter is not interfered with. Examples of the dopant include n-type dopants such as tin (Sn), germanium (Ge), silicon (Si), titanium (Ti), zirconium (Zr), vanadium (V), and niobium (Nb) or a p-type dopant. The dopant concentration, in general, may be approximately in a range of 1×10¹⁶/cm³ to 1×10²²/cm³, or the dopant concentration may be set at low concentration of, for example, approximately 1×10¹⁷/cm³ or less. Also, according to an embodiment of the present subject matter, the dopant may be contained to be at high concentration of approximately 1×10²⁰/cm³ or more. According to an embodiment of the present inventive subject matter, the dopant is preferably contained such that carrier concentration of a crystalline oxide semiconductor layer becomes 1×10¹⁷/m³ or more. Also, in a semiconductor device having a withstand voltage of 600 V, for example, including a gallium oxide-based crystalline oxide semiconductor layer including at least one trench according to the present subject matter, carrier concentration of the gallium oxide-based crystalline oxide semiconductor layer is able to be in a range of 1×10¹⁷/cm³ or more and 3×10¹⁷/cm³ or less, for example.

A solvent of the raw material solution is not particularly limited, and may be an inorganic solvent such as water, etc., also may be an organic solvent such as alcohol, etc., and also may be a mixed solvent of an inorganic solvent and an organic solvent. In the present inventive subject matter, the solvent preferably contains water, and the solvent is further preferably water or a mixed solvent of water and alcohol.

### (Carrying atomized droplets into a film-formation chamber)

In carrying atomized droplets, the atomized droplets are carried into a film (layer)-formation chamber by carrier gas. The carrier gas is not particularly limited as long as an object of the present inventive subject matter is not interfered with, and thus, as the carrier gas, oxygen, ozone, an inert gas such as nitrogen, argon, etc., and a reducing gas such as a hydrogen gas, a forming gas, etc. may be named as preferable examples. The type of carrier gas may be one or two or more types, and a dilution gas at a reduced flow rate (e.g., 10-fold dilution gas) or the like may be used further as a second carrier gas. The carrier gas may be supplied from one or two or more locations. The flow rate of the carrier gas is not particularly limited, however, the flow rate of the carrier gas is preferably 0.01 L/min to 20 L/min, and further preferably 1 L/min to 10 L/min. When a dilution gas is used, the flow rate of the dilution gas is preferably 0.001 L/min to 2 L/min, and further preferably 0.1 L/min to 1 L/min.

### (Forming a film)

For forming a film, the atomized droplets carried into the film (layer)-formation chamber by carrier gas are thermally reacted (through "thermal reaction") to form a semiconductor layer on a base that is arranged in the film (layer)-formation chamber. Herein, "thermal reaction" only requires that the atomized droplets react by heat, and conditions of reaction are not particularly limited as long as an object of the present inventive subject matter is not interfered with. and thus, the term "thermal reaction" herein may include a chemical reaction, and/or a physical reaction. The "thermal reaction" herein may include another reaction, and conditions of reaction are not particularly limited as long as an object of a present inventive subject matter is not interfered with. In this process, the thermal reaction is conducted at an evaporation temperature or higher temperatures of the evaporation temperature of the solvent of the raw material solution, however, a range of temperature for the "thermal reaction" are not too high and may be below 1000 °C, and further preferably 650 °C or less, and most preferably 300 °C to 650 °C. Also, the thermal reaction may be conducted in any atmosphere of a vacuum, a non-oxygen atmosphere, a reducing-gas atmosphere, and an oxygen atmosphere as long as an object of the present inventive subject matter is not interfered with, however, in a non-oxygen atmosphere or in an oxygen atmosphere is preferable. Also, the thermal reaction may be conducted in any condition of under an atmospheric pressure, under an increased pressure, and under a reduced pressure, however, according to the present inventive subject matter, the thermal reaction is preferably conducted under an atmospheric pressure. Also, a film (layer) thickness of crystalline oxide semiconductor film (layer) is able to be set by adjusting a film (layer)-formation time.

### (Base)

As a base, the base is not particularly limited as long as the base is able to support a semiconductor layer to be formed on the base. Herein, "a semiconductor layer" and/or "the semiconductor layer" may be the first semiconductor layer and/or the second semiconductor layer. Furthermore, a material for the base is not particularly limited as long as an object of the present inventive subject matter is not interfered with, and also, the material may be a known one. The base may be made of a material of an organic compound. Also, the base may be made of a material of an inorganic compound. The base may have a plate shape. Examples of the shape of the base further include a circular plate shape, a shape of fiber, a shape of a stick, a shape of a round pillar, a shape of a square pillar, a shape of a tube, a shape of a spiral, a shape of a sphere and a shape of a ring. According to embodiments of a present inventive subject matter, the base is preferably a substrate. The thickness of the substrate is not particularly limited according to the present inventive subject matter.

The substrate is not particularly limited as long as the substrate has a plate shape and is able to support the semiconductor film. The substrate may be an insulating substrate, a semiconductor substrate, a metal substrate, or an electrically-conductive substrate, however, the substrate is preferably an insulating substrate, and a substrate having a metal film(s) on a surface thereof is also preferable. Examples of the substrate include a base substrate containing as a major component a substrate material with a corundum structure, a base substrate containing as a major component a substrate material with a β-gallia structure, a base substrate containing as a major component a substrate material with a hexagonal structure, and the like. The "major component" herein means to have the above-mentioned crystal structure, and, based on entire components of the substrate, becomes, at an atomic ratio, preferably 50% or more, further preferably 70% or more, and even more preferably 90% or more, and may be 100%.

In components of the substrate material is not particularly limited as long as the object of the present inventive subject matter is not interfered with, and may be a known one. Preferred examples of the substrate material with a corundum structure include α-Al₂O₃ (sapphire substrate) and α-Ga₂O₃, and more preferred examples include an a-plane sapphire substrate, an m-plane sapphire substrate, an r-plane sapphire substrate, a c-plane sapphire substrate, an α gallium oxide substrate (a-plane, m-plane, or r-plane), and the like. Examples of the base substrate containing as a major component the substrate material with a β-gallia structure include a β-Ga₂O₃ substrate, a mixed crystal substrate containing Ga₂O₃, and Al₂O₃, wherein Al₂O₃ is more than 0 wt% and 60 wt% or less, and the like. Examples of the base substrate containing the substrate material with a hexagonal structure as a major component include an SiC substrate, a ZnO substrate, a GaN substrate.

In an embodiment, after a film is formed, it is also preferable that annealing is carried out. The annealing temperature is not particularly limited as long as an object of the present inventive subject matter is not interfered with, and is generally carried out at a temperature of 300 °C to 650 °C and preferably 350 °C to 550 °C. Also, the annealing time is generally one minute to 48 hours, preferably 10 minutes to 24 hours, and further preferably 30 minutes to 12 hours. The annealing treatment may be carried out in any atmosphere as long as an object of the present inventive subject matter is not interfered with, however, preferably in a non-oxygen atmosphere or in a nitrogen atmosphere.

In embodiments of the present inventive subject matter, the semiconductor film may be arranged directly on the base or may be arranged on another layer, such as a buffer layer(s) and a stress relief layer(s) arranged on the base. A method(s) of forming each layer is not particularly limited and may be a known method, however, in embodiments of the present inventive subject matter, a mist CVD method is preferable.

Also, according to the present subject matter the crystalline oxide semiconductor layer contains at least gallium and has a corundum structure. According to the invention, the crystalline oxide semiconductor layer consists however of α-Ga₂O₃. As an embodiment, the semiconductor film may be separated from the base or the like or the base and another layer by a known method, and then, may be used as a semiconductor region, or may be used as it is in a semiconductor device. Furthermore, as a preferable embodiment, the crystalline oxide semiconductor layer includes two or more trenches. Also, the trench(es) has a width that is 2 µm or less, and the crystalline oxide semiconductor layer preferably includes four or more trenches. The two or more trenches are spaced from one another and arranged in the crystalline oxide semiconductor layer at a side of the first surface of the crystalline oxide semiconductor layer. According to such an embodiment, the semiconductor device is able to be more suitable for a power device and obtain an enhanced semiconductor property, and that leads to miniaturization of the semiconductor device. The trench of the crystalline oxide semiconductor layer has at least one arc portion between the bottom and the side of the trench, the at least one arc portion with a radius of curvature that is in a range of 100 nm to 500 nm. When the crystalline oxide semiconductor layer includes a trench with two or more arc portions, each radius of curvature of the arc portions requires to be in a range of 100 nm to 500 nm. According to an embodiment the present inventive subject matter, in a case that the crystalline oxide semiconductor layer includes two or more arc portions, the two or more arc portions with radiuses of curvature that are in a range of 100 nm to 500 nm, and the radiuses of curvature of all of the arc portions are further preferably in a range of 100 nm to 500 nm.

The trench(es), for example, is able to be formed by a dry etching method with high pressure or the like. More specifically, for example, a method at least including etching a crystalline oxide with plasma etching gas, and wherein the pressure of the etching gas is in a range of 1 Pa or more and 10 Pa or less is named. In the etching method, the pressure of the etching gas is preferably 2 Pa or more. Also, it is preferable that the plasma etching gas contains at least halogen. It is also preferable that the plasma etching gas contains at least gallium. It is also preferable that the etching is performed under an inert gas atmosphere. Also, it is preferable that the inert gas is argon. Also, it is preferable that the etching is performed in a halogen gas atmosphere. Also, it is preferable that the bias of the plasma of etching gas is 25W or more. With such a preferable etching method, it is possible to easily form trenches.

Some embodiments are explained in more details using figures as follows, however, the present inventive subject matter is not limited thereto.

According to an embodiment of the present inventive subject matter, a crystalline oxide semiconductor layer 3 (that may be called a semiconductor region) consists of α-Ga₂O₃ and includes at least one trench 7 formed in the crystalline oxide semiconductor layer 3 at a side of a first surface 3a. The trench 7 includes a bottom, a side, and at least one arc portion between the bottom and the side of the trench 7. Also, the crystalline oxide semiconductor layer 3 is electrically connected to at least one electrode. An embodiment of a semiconductor device according to the present inventive subject matter is applicable to a semiconductor device including a trench. For example, FIG. 1 shows a junction barrier Schottky (JBS) diode, which is one of embodiments of the present inventive subject matter. The semiconductor device in FIG. 1 includes a semiconductor region 3, a first electrode as a barrier electrode 2 that is arranged on and/or above the semiconductor region 3 and capable of forming a Schottky barrier between the semiconductor region 3 and the barrier electrode 2, and a barrier height adjustment region(s) 1 that is arranged between the barrier electrode 2 and the semiconductor region 3 and capable of forming a Schottky barrier with a greater barrier height between the barrier height adjustment region(s) and the semiconductor region 3 than the barrier height of the Schottky barrier between the barrier electrode and the semiconductor region 3. The barrier height adjustment region(s) 1 is each arranged in one of the trench(es) 7 provided at the side of the first surface 3a in the semiconductor region 3. According to embodiments of the present inventive subject matter, it is preferable that the two or more barrier height adjustment regions each arranged in one of the two or more trenches are spaced from one another at a regular interval. Also, it is further preferable that between both ends of the barrier electrode, in the semiconductor region, the barrier height adjustment region(s) are respectively arranged. FIG. 1 shows a cross section of a JBS diode, and the two or more barrier height adjustment regions are connected to one another, for example, in a plan view. According to such a preferred configuration, the JBS diode is configured to be superior in thermal stability and in adhesion, and leakage current is able to be further reduced, and furthermore, a semiconductor property such as a high withstand voltage is able to be achieved. The semiconductor device of FIG. 1 includes a second electrode as an ohmic electrode 4 at the side of the second surface 3b of the semiconductor region 3. The semiconductor device of FIG. 1 includes a trench(es) 7 that includes an arc portion 15c between the bottom 7a and the side 7b of the trench 7, and the arc portion has a radius of curvature that is in a range of 100 nm to 500 nm, and that results in obtaining an enhanced electric field relaxation effect, and as a result, it is possible to reduce on-resistance.

Method(s) of forming each layer of the semiconductor device of FIG. 1 are not particularly limited as long as an object of the present inventive subject matter is not interfered with, and may be known method(s). For example, forming a film with a method such as a vacuum evaporation method, a CVD method, a spattering method, or various coating technologies and then, patterning is performed on the film by photolithography, or directly patterning by use of printing technology or the like.

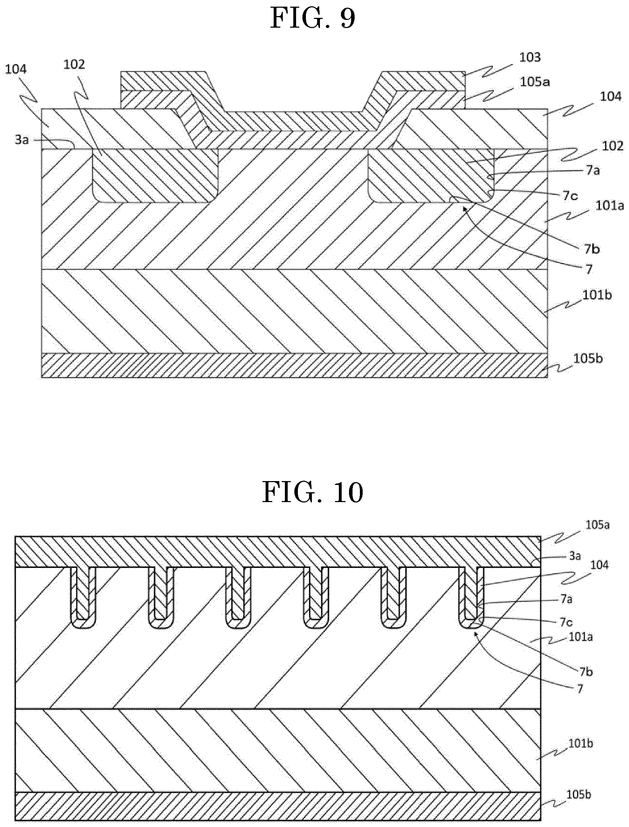

FIG. 9 shows an example of a junction barrier Schottky (JBS) diode, which is one of embodiments of the present inventive subject matter. The semiconductor device in FIG. 9 includes an n⁻-type semiconductor layer 101a, an n⁺-type semiconductor layer 101b, a dielectric layer 104, a Schottky electrode 105a and an ohmic electrode 105b. Also, the SBD includes trench(es) 7 including an arc portion 7c between the bottom 7a and the side 7b of the trench 7, the arc portion with the radius of curvature that is in a range of 100 nm to 500 nm, and to realize an excellent electric field relaxation effect and to reduce the on-resistance. In the trench(es) 7, a p-type semiconductor layer 102 is buried.

Electrode material(s) of Schottky and ohmic electrodes may be known electrode material(s). Examples of the electrode material(s) include metals such as Al, Mo, Co, Zr, Sn, Nb, Fe, Cr, Ta, Ti, Au, Pt, V, Mn, Ni, Cu, Hf, W, Ir, Zn, In, Pd, Nd, Ag, or alloy(s) thereof, metal oxide conductive films such as tin oxide, zinc oxide, indium oxide, indium tin oxide (ITO), and indium zinc oxide (IZO), organic conductive compounds such as polyaniline, polythiophene, and polypyrrole, and combination(s) of these materials.

Formation of Schottky and ohmic electrodes is able to be performed by a known method(s) such as, for example, a vacuum evaporation method or a sputtering method. More specifically, for example, when a Schottky electrode is formed, a layer of Mo and a layer of Al are arranged to have a layered structure, on that patterning is performed with a technique of photolithography.

When a reverse bias is applied to the SBD shown in FIG. 9, with a stress relaxation effect at the arc portion of the trench 7, a depletion layer (not shown) extends in good conditions into the n-type semiconductor layer 101a as a crystalline oxide semiconductor layer, so that the SBD becomes an SBD with a high breakdown voltage. Also, when a forward bias is applied to the SBD, electrons flow from the ohmic electrode 105b, that is positioned at a side of a second surface opposite to a first surface of the crystalline oxide semiconductor layer to the Schottky electrode 105a, that is positioned at a side of the first surface of the crystalline oxide semiconductor layer. Accordingly, the SBD becomes a high-voltage SBD and a large current is applicable to the SBD with enhanced switching speed, voltage and reliability.

Examples of material(s) of a dielectric layer 104 include GaO, AlGaO, InAlGaO, AlInZnGaO₄, AlN, Hf₂O₃, SiN, SiON, Al₂O₃, MgO, GdO, SiO₂, and Si₃N₄. By arranging such an insulator as an insulating layer, semiconductor properties are able to function at an interface in good conditions. The dielectric layer 104 is arranged between the n⁻-type semiconductor layer 101 and a Schottky electrode 105a. Forming the insulation layer is able to be performed by a known method such as a spattering method, a vacuum evaporation method, and a CVD method.

FIG. 10 shows an example of a trench Schottky Barrier Diode (SBD) including an n⁻-type semiconductor layer 101a as a crystalline oxide semiconductor layer, two or more trenches 7 arranged at a side of the first surface of the n-type semiconductor layer 101a, an n⁺-type semiconductor layer 101b, a dielectric layer 104, a Schottky electrode 105a, and an ohmic electrode 105b. The trench SBD in FIG. 10 has a structure including a trench with an arc portion. According to such a trench SBD, it is possible to maintain a higher voltage and to greatly decrease leak current, and as a result, it is possible to greatly reduce on-resistance.

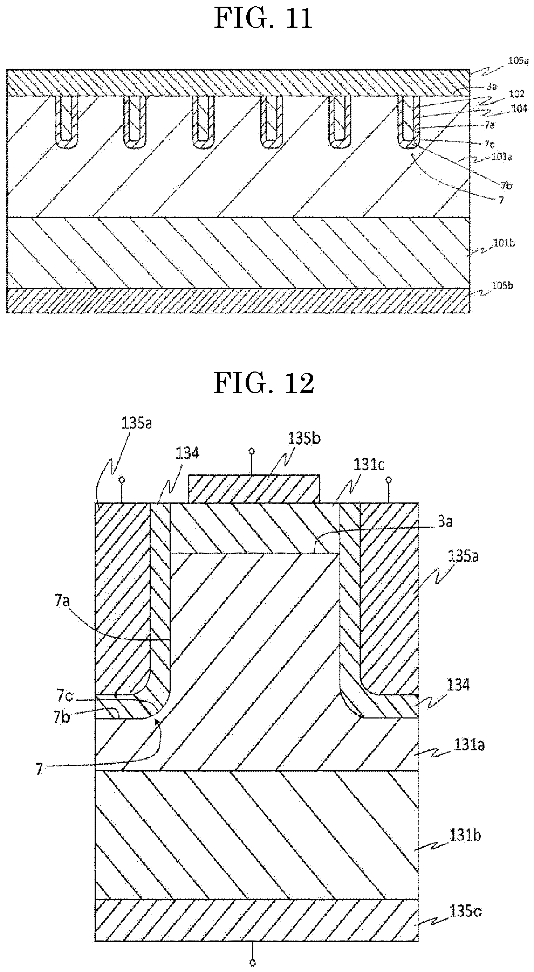

FIG. 11 shows an example of a Junction Barrier Schottky (JBS) diode including an n⁻-type semiconductor layer 101a, an n⁺-type semiconductor layer 101b, and a p-type semiconductor layer 102, a dielectric layer 104, a Schottky electrode 105a, and an ohmic electrode 105b. The JBS diode in FIG. 11 includes a trench 7 including an arc portion, and the p-type semiconductor layer 102 is arranged in the trench 7. According to such a JBS diode, it is possible to maintain a higher voltage than the trench SBD in FIG. 10 while leak current is able to be greatly decreased, and also it is possible to greatly reduce on-resistance.

FIG. 12 shows an example of a semiconductor device that is a MOSFET according to the present inventive subject matter. The MOSFET in FIG. 12 is a trench MOSFET including an n⁻-type semiconductor layer 131a as a crystalline oxide semiconductor layer, the n⁻-type semiconductor layer 131a including a trench(es) 7, a first n⁺-type semiconductor layer 131b, a second n⁺-type semiconductor layer 131c, a gate insulation film 134, a gate electrode 135a, a source electrode 135b, and a drain electrode 135c.

On the drain electrode 135c, for example, the first n⁺-type semiconductor layer 131b that has a thickness of 100 nm to 100 µm is formed, and on the first n⁺-type semiconductor layer 131b, for example, the n-type semiconductor layer 131a that has a thickness of 100 nm to 100 µm is formed. Also, on the n⁻-type semiconductor layer 131a, the second n⁺-type semiconductor layer 131c is formed, and on the second n⁺-type semiconductor layer 131c, the source electrode 135b is formed.

Also, in the n⁻-type semiconductor layer 131a and the second n⁺-type semiconductor layer 131c, trenches penetrating the second n⁺-type semiconductor layer 131c and reaching the middle of n⁻-type semiconductor layer 131a are formed. In each of the trenches, for example, a gate electrode 135a is buried in the trench through a gate insulation film 134 having a thickness of 10 nm to 1 µm and arranged in the trench, for example.

In the state of "on" of the MOSFET shown in FIG. 12, by applying a voltage between the source electrode 135b and the drain electrode 135c, when a positive voltage with respect to the source electrode 135b is applied to the gate electrode 5a, a channel region is formed at a side of the n⁻-type semiconductor layer 131a, electrons are injected in the n⁻-type semiconductor layer and the MOSFET becomes turned off. In the state of "off", by setting the voltage of the gate electrode to zero, the channel layer is not formed and the n⁻-type semiconductor layer 131a is in a condition to be filled with a depletion layer, and thus, that results in a turn-off.

In manufacturing the MOSFET in FIG. 12, a known method may be used if necessary. For example, arranging a mask for etching in a region of an n⁺-type semiconductor layer 131c and an n⁻-type semiconductor layer 131a, performing etching by the above-mentioned method of dry etching with high pressure to form trenches 7 from a surface of the n⁺-type semiconductor layer 131c to a middle of the n⁻-type semiconductor layer 131a and the arc portions are formed together with the trenches 7. Then, by a known method such as a thermal oxidation method, a vacuum evaporation method, a spattering method, a CVD method, on the sides and the bottom of the trench 7, for example, a gate insulation 134 is formed to have a thickness that is 50 nm to 1µm, for example, and then, a gate electrode material(s) such as polysilicon is formed to have a thickness that is the same thickness or thinner than the n⁻-type semiconductor layer 131a by a CVD method, a vacuum evaporation method, or a spattering method. Then, by a known method such as a vacuum evaporation method, a spattering method or a CVD method, a power MOSFET is able to be manufactured by forming a source electrode 135b on the n⁺-type semiconductor layer 131c and forming a drain electrode 135c on the n+-type semiconductor layer 131b. Material(s) of the source electrode and the drain electrode may be known electrode material(s). Examples of the electrode material(s) include metals such as Al, Mo, Co, Zr, Sn, Nb, Fe, Cr, Ta, Ti, Au, Pt, V, Mn, Ni, Cu, Hf, W, Ir, Zn, In, Pd, Nd, Ag, or alloy(s) thereof, metal oxide conductive films such as tin oxide, zinc oxide, indium oxide, indium tin oxide (ITO), and indium zinc oxide (IZO), organic conductive compounds such as polyaniline, polythiophene, and polypyrrole, and combination(s) of these materials.

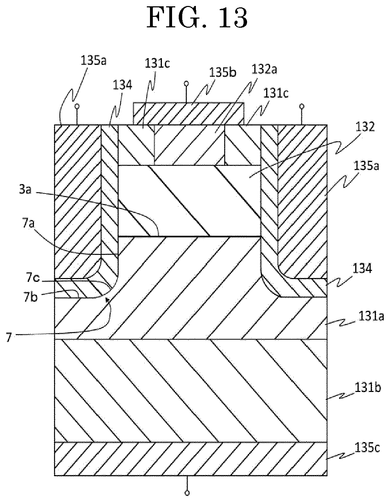

A MOSFET obtained as mentioned above becomes to have more enhanced semiconductor property than a conventional trench MOSFET. Also, FIG. 12 shows a vertical trench MOSFET, however, the present inventive subject matter is not limited thereto, and applicable to various aspects of trench MOSFET. For example, the depth of the trench groove may be formed to reach the bottom of the n⁻-type semiconductor layer 131a in order to decrease series resistance. Also, an example of another trench MOSFET is shown in FIG. 13.

Fig. 13 shows an example of a metal oxide semiconductor field effect transistor (MOSFET) including an n⁻-type semiconductor layer 131a, a first n⁺-type semiconductor layer 131b, and a second n-type semiconductor layer 131c, a p-type semiconductor layer 132, a p⁺-type semiconductor layer 132a, a gate-insulating film 134, a gate electrode 135a, a source electrode 135b, and a drain electrode 135c. The p⁺-type semiconductor layer 132a may be a p-type semiconductor layer, and may be of the same material of the p-type semiconductor layer 132.

The semiconductor device is particularly useful for power devices. Also, as an embodiment of the present inventive subject matter, the semiconductor device is preferably a vertical semiconductor device. Examples of the semiconductor device include a diode, and a transistor (such as a MESFET, for example), and the semiconductor device is particularly suitable for a diode, and further suitable for a Junction Barrier Schottky Diode (JBS).

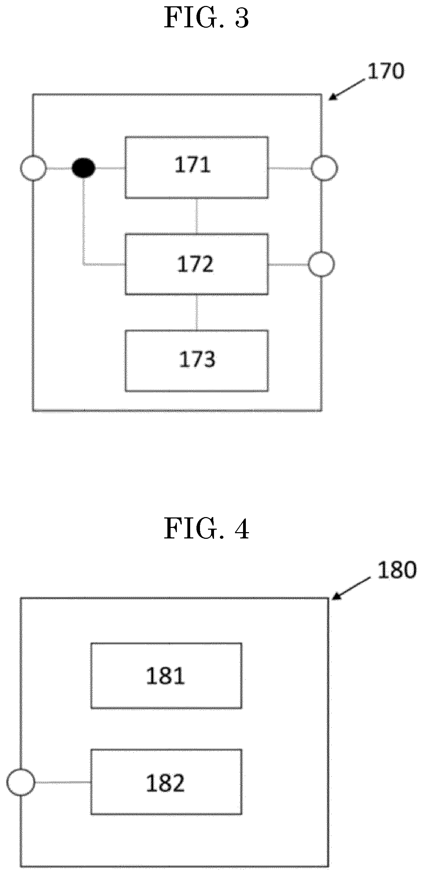

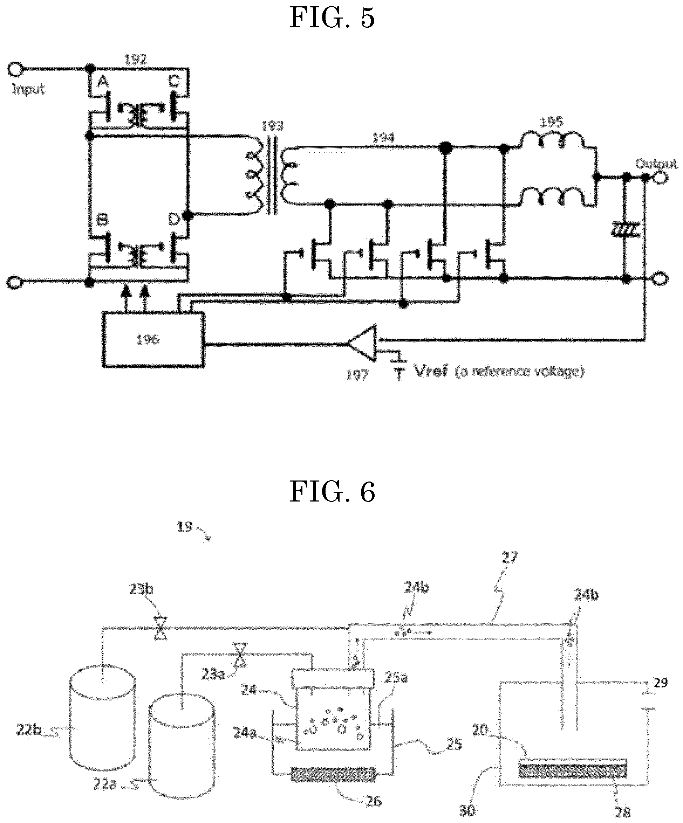

A semiconductor device according to the present inventive subject matter is, provided with the mentioned above, able to be suitably used as a power module, inverter, or converter, using further known methods, and is also suitably used in, for example, semiconductor systems using a power device. The power device can be obtained from the semiconductor device or obtained as a semiconductor device by connecting the semiconductor device to wiring patterns by using a known method, for example. FIG. 3 shows a power system 170 including two or more power devices 171, 172, and a control circuit 173. The power system 170, as shown in FIG. 4, may be combined with an electric circuit 181 and a power system 182 for a system device 180. FIG. 5 shows a schematic view of a power source circuit of a power source device. FIG. 5 illustrates a power supply circuit of a power device, including a power circuit and a control circuit. A DC voltage is switched at high frequencies by an inverter 192 (configured with MOSFET A to D) to be converted to AC, followed by insulation and transformation by a transformer 193. The voltage is then rectified by rectification MOSFET (A~B') and then smoothed by a DCL 195 (smoothing coils L1 and L2) and a capacitor to output a direct current voltage. At this point, the output voltage is compared with a reference voltage by a voltage comparator 197 to control the inverter and the rectification MOSFET 194 by a PWM control circuit 196 to have a desired output voltage.

### [Practical Example]

Some practical examples according to the present inventive subject matter are explained as follows, however, the present inventive subject matter is not limited thereto.

### (Practical Example 1)

### 1. Forming a semiconductor layer

### 1-1. a film (layer)-formation apparatus

With reference to FIG. 6, a mist CVD apparatus 19 used in Practical Examples is explained. The mist CVD apparatus 19 shown in FIG. 6 includes a carrier gas supply device 22a, a flow-control valve 23a to control a flow of carrier gas that is configured to be sent from the carrier gas supply device 22a, a carrier gas (dilution) supply device 22b, a flow-control valve 23b to control a flow of carrier gas that is configured to be sent from the carrier gas (dilution) supply device 22b, a mist generator 24 in that a raw material solution 24a is contained, a container 25 in that water 25a is contained, and an ultrasonic transducer 26 attached to a bottom surface of the container 25. The mist CVD apparatus 19 further includes a film-formation chamber 30, a supply pipe 27 that is a quartz pipe connecting the mist generator 24 and the film-formation chamber 30, and a hot plate (heater) 28 arranged in the film-formation chamber 30. A substrate 20 is arranged on the hot plate 28.

### 1-2. Preparation of Raw-material solution

A raw-material solution was prepared by mixing hydrobromic acid to be 10 % in volume ratio into an aqueous solution of 0.1M gallium bromide.

### 1-3. Preparation of Film-Formation

The raw material solution 24a obtained at the above 1-2. was contained in the mist generator 24. Then, as a substrate 20, a sapphire substrate was placed on a heater 28, and the heater 28 was activated to raise the temperature in the film-formation chamber 30 up to 630°C. Then, the flow-control valves 23a and 23b were opened to supply carrier gas from carrier gas supply devices 22a and 22b to the film-formation chamber 30 to replace the atmosphere in the film-formation chamber 30 sufficiently with the carrier gas. After that, the flow of the carrier gas was adjusted to be 1.0 L/min, and the flow of the carrier gas (dilution) was adjusted to be 2.0 L/min. As the carrier gas, nitrogen was used.

### 1-4. Formation of Semiconductor Film

Next, the ultrasonic transducer 26 was activated to oscillate at 2.4 MHz, and the oscillation caused by the ultrasonic transducer was propagated through water 25a to the raw-material solution 24a to atomize the raw-material solution 24a to form atomized particles of the raw material. The atomized particles were introduced in the film-formation chamber 30 by the carrier gas, and the atomized particles were thermally reacted in the film-formation chamber 30 under an atmospheric pressure at a temperature that was 630 °C. Accordingly, a semiconductor film was formed on the substrate 20. The thickness of the film was 4.1 µm and the film-formation time was 105 minutes.

### 1-5. Evaluation

Phase of the film obtained at the above 1-4. was identified by an X-ray diffraction (XRD) instrument as a film of α-Ga₂O₃.

### 2. Etching

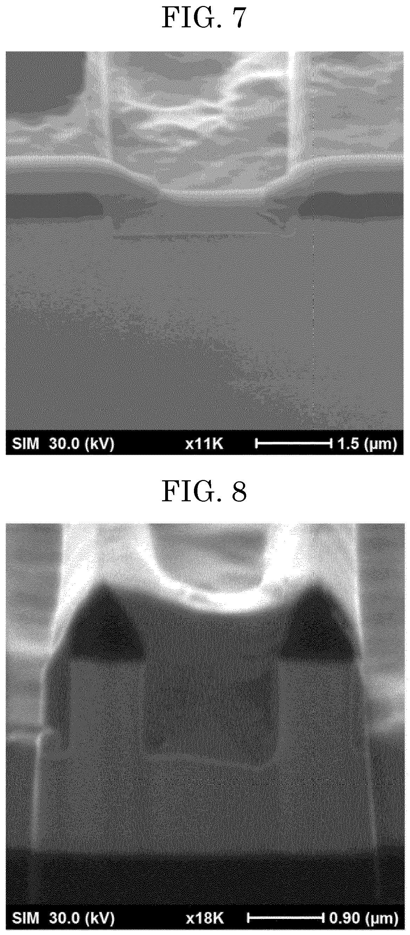

Under conditions indicated in the following Table 1, trenches were formed in the semiconductor film by an inductively-coupled plasma reactive-ion etching (ICP-RIE) apparatus. Arc portions of the trenches have radiuses of curvatures that are in a range of 100 nm or more to 500 nm or less. FIG. 7 is a picture showing a trench in cross-section, formed as the Practical Example 1. As shown in FIG. 7, radiuses of curvatures in the Practical Example 1 were 140 nm at R1 (left side) and 160 nm at R2 (right side). Also, the side of the trench includes a taper angle that was 60°. As clearly shown in FIG. 7, trenches were formed in good conditions.

**[Table 1]**

| | Practical Example 1 | Practical Example 2 | Comparative Example 1 | Comparative Example 2 |
|---|---|---|---|---|
| Cl₂ (sccm) | 50 | 0 | 50 | 0 |
| Ar (sccm) | 0 | 50 | 0 | 50 |
| BCl₃ (sccm) | 20 | 20 | 20 | 20 |
| Pressure (Pa) | 5 | 5 | 0.5 | 11 |
| ICP input power (W) | 100 | 1000 | 100 | 1000 |
| Substrate bias voltage (bias) (W) | 52 | 150 | 50 | 200 |

### (Practical Example 2)

Trenches were formed by the same conditions as the conditions of the Practical Example 1 except that etching was performed under conditions indicated in the Table 1 to form trenches. FIG. 8 shows a picture of a trench in cross-section, and radiuses of curvatures of the trench were 125 nm at R1 (left side) and 298 nm at R2 (right side). As clearly shown in FIG. 8, the trench with arc portions was formed in good conditions.

**[Table 2]**

| | Practical Example 3 |
|---|---|
| Cl₂ (sccm) | 0 |
| Ar (sccm) | 20 |
| BCl₃ (sccm) | 70 |
| Pressure (Pa) | 10 |
| ICP input power (W) | 500 |
| Substrate bias voltage (bias)(W) | 25 |

### (Practical Example 3)

Trenches were formed in a semiconductor film (that may be mentioned as a crystalline oxide semiconductor layer) by the same conditions as the conditions of the Practical Example 1 except that etching was performed under conditions indicated in the Table 2 to form trenches. The trenches that were obtained are shown in FIG. 16-a. Also, FIG. 16-b is an explanatory picture using the same picture of the cross section of the trench in FIG. 16-a. The first arc portion 7ca has a radius of curvature R1 (at the left side shown in FIG. 16-b) that was 220 nm, and the second arc portion 7cb has a radius of curvature R2 (at the right side shown in FIG. 16-b) that was also 220 nm. A plurality of trenches 7 were formed in the crystalline oxide semiconductor layer 3, and the radius of curvature R1 of the first arc portion 7ca is equivalent to the radius of curvature R2 of the second arc portion 7cb in each of the trenches 7. The trench 7 has a width that becomes narrower toward the bottom 7b of the trench 7. As shown in the cross section of the trench 7, an angle (θ1 shown in FIG. 16-b) between a side 7a (a first side 7aa) of the trench 7 and the first surface 3a of the crystalline oxide semiconductor layer 3 was in a range of greater than 90° to 135° or less. Also, an angle (θ2 shown in FIG. 16-b) between a side 7a (a first side 7ab) of the trench 7 and the first surface 3a of the crystalline oxide semiconductor layer 3 was in a range of greater than 90° to 135° or less. Also, FIG. 16-b shows a mask that is indicated as SiO₂, and the mask was arranged on the first surface 3a of the crystalline oxide semiconductor layer 3 for etching the crystalline oxide semiconductor layer 3 to form trenches 7 in the crystalline oxide semiconductor layer 3, and eventually removed. Also, by changing the flow rate of BCl₃, it was found that trenches having arc portions are able to be formed in good conditions when the flow rate of BCl₃ is set in a range of 50 sccm to 100 sccm.

According to the Practical Examples 1 to 3, the crystalline oxide semiconductor layer in each of the Practical Examples includes at least one trench in the crystalline oxide semiconductor layer at a side of a first surface of the crystalline oxide semiconductor layer, and the trench includes a bottom, a side, and at least one arc portion with a radius of curvature that is in a range of 100 nm to 500 nm. The at least one arc portion is positioned between the bottom and the side, and an angle between the side of the trench and the first surface of the crystalline oxide semiconductor layer is greater than 90° to 135° or less. With such a configuration, electric-field relaxation effect is sufficiently obtained in a semiconductor device including a gallium oxide-based crystalline oxide semiconductor film. As a result, on-resistance of a semiconductor device including the gallium oxide-based semiconductor layer was able to be decreased. Also, according to the Practical Example 3, it is possible to form trenches each having arc portions with equivalent radius of curvature, on-resistance of the semiconductor device is expected to be further decreased.

### (Comparative Example 1)

Trenches were formed by the same conditions as the conditions of the Practical Example 1 except that etching was performed under conditions indicated in the Table 1 to form trenches. A trench was formed to include a bottom with a convex shape and a corner between the bottom and a side, and the trench was not formed in good quality.

### (Comparative Example 2)

Trenches were formed by the same conditions as the conditions of the Practical Example 1 except that etching was performed under conditions indicated in the Table 1 to form trenches. The trench that was obtained included sides that were reverse tapered and shaved off, and an inner width in the trench became wider than a width at an opening of the trench. An arc portion between the bottom and the side of the trench was formed, however, the arc portion became bigger with a radius of curvature that was 1 µm or more, and thus, the trench that is not in good quality was obtained.

### [Industrial Applicability]

Semiconductor devices according to the present inventive subject matter are able to be used for semiconductors (for example, chemical compound semiconductor electronic devices etc.), electronic components, parts of electronic appliances, optical and electronic photo-related devices, and industrial members in various fields, and especially useful for power devices.

### [Reference Number Description]

- 1: a barrier height adjustment region
- 2: a barrier electrode
- 3: a semiconductor layer
- 3a: a first surface
- 3b: a second surface
- 4: an ohmic electrode
- 7: a trench
- 7a: a side of a trench
- 7b: a bottom of a trench
- 7c: an arc portion of a trench
- 19: mist CVD apparatus (film-formation apparatus)
- 20: a substrate
- 22a: a carrier gas supply device
- 22b: a carrier gas (dilution) supply device
- 23a: a flow-control valve of carrier gas
- 23b: a flow-control valve of dilution carrier gas
- 24: a mist generator
- 24a: a raw material solution
- 25: a container
- 25a: water
- 26: an ultrasonic transducer
- 27: a supply pipe
- 28: a heater
- 29: an exhaust port
- 30: a film-formation chamber
- 101a: an n⁻-type semiconductor layer
- 101b: an n⁺-type semiconductor layer
- 102: a p-type semiconductor layer
- 103: a metal layer
- 104: a dielectric layer
- 105a: a Schottky electrode
- 105b: an Ohmic electrode
- 131a: an n⁻-type semiconductor layer
- 131b: a first n⁺-type semiconductor layer
- 131c: a second n⁺-type semiconductor layer
- 132: a p-type semiconductor layer
- 132a: a p⁺-type semiconductor layer
- 134: a gate insulation layer
- 135a: a gate electrode
- 135b: a source electrode
- 135c: a drain electrode
- 170: a power system
- 171: a power device
- 172: a power device
- 173: a control circuit
- 180: a system device
- 181: an electric circuit
- 182: a power system
- 192: an inverter
- 193: a transformer
- 194: a rectification MOSFET
- 195: a DCL
- 196: a PWM control circuit
- 197: a voltage comparator

## Claims

1. A semiconductor device comprising:
a crystalline oxide semiconductor layer (3); and
at least one electrode (2, 4) electrically connected to the crystalline oxide semiconductor layer (3),
wherein the crystalline oxide semiconductor layer (3) consists of α-Ga₂O₃,
wherein the crystalline oxide semiconductor layer (3) comprises at least one trench (7) in the crystalline oxide semiconductor layer (3) at a side of a first surface (3a) of the crystalline oxide semiconductor layer (3),
wherein the trench (7) comprises a bottom (7b), a side (7a), and at least one arc portion (7c) positioned between the bottom (7b) and the side (7a) with a radius of curvature that is in a range of 100 nm to 500 nm,
wherein the trench (7) has a width that is 2 µm or less, and
wherein an angle between the side (7a) of the trench (7) and the first surface (3a) of the crystalline oxide semiconductor layer (3) is 90° or more.

2. The semiconductor device of claim 1, wherein the angle between the side (7a) of the trench (7) and the first surface (3a) of the crystalline oxide semiconductor layer (3) is 150° or less.

3. The semiconductor device of claim 1 or 2, wherein the width of the trench (7) becomes narrower toward the bottom (7b) of the trench (7).

4. The semiconductor device of any of claims 1 to 3, wherein the side (7a) of the trench (7) is tapered.

5. The semiconductor device of claim 4, wherein the angle between the side (7a) of the trench (7) and the first surface (3a) of the crystalline oxide semiconductor layer (3) is in a range of greater than 90° to 135° or less.

6. The semiconductor device of any of claims 1 to 5, wherein the crystalline oxide semiconductor layer (3) comprises two or more trenches (7).

7. The semiconductor device of claim 6
wherein the crystalline oxide semiconductor (3) layer comprises four or more trenches (7).

8. The semiconductor device of any of claims 1 to 7, wherein the semiconductor device (3) is a power device (171) and/or vertical semiconductor device.

9. The semiconductor device of any of claims 1 to 8, wherein the semiconductor device is a diode or a transistor.

10. The semiconductor device of any of claims 1 to 9, wherein the semiconductor device is a junction barrier Schottky diode (105a).

11. The semiconductor device of any of claims 1 to 10,
wherein the at least one electrode (2, 4) comprises a first electrode (2) electrically connected to the crystalline oxide semiconductor layer (3) and a second electrode (4) electrically connected to the crystalline oxide semiconductor layer (3), and
wherein the first electrode (2) is positioned closer to the first surface (3a) of the crystalline oxide semiconductor layer (3) than the second electrode (4), and the second electrode (4) is positioned closer to a second surface (3b) of the crystalline oxide semiconductor layer (3) than the first electrode (2), the second surface (3b) being opposite to the first surface (3a).

12. A system comprising:
a semiconductor device of any of claims 1 to 11.

## Patentansprüche

1. Halbleiterbauelement, umfassend:
eine kristalline Oxid-Halbleiterschicht (3); und
mindestens eine Elektrode (2, 4), die elektrisch mit der kristallinen Oxid-Halbleiterschicht (3) verbunden ist,
wobei die kristalline Oxid-Halbleiterschicht (3) aus α-Ga₂O₃ besteht,
wobei die kristalline Oxid-Halbleiterschicht (3) mindestens eine Furche (7) in der kristallinen Oxid-Halbleiterschicht (3) auf einer Seite einer ersten Fläche (3a) der kristallinen Oxid-Halbleiterschicht (3) umfasst,
wobei die Furche (7) einen Boden (7b), eine Seite (7a) und mindestens einen Bogenabschnitt (7c), der zwischen dem Boden (7b) und der Seite (7a) positioniert ist, mit einem Krümmungsradius umfasst, der in einem Bereich von 100 nm bis 500 nm liegt,
wobei die Furche (7) eine Breite aufweist, die 2 µm oder weniger beträgt, und
wobei ein Winkel zwischen der Seite (7a) der Furche (7) und der ersten Fläche (3a) der kristallinen Oxid-Halbleiterschicht (3) 90° oder mehr beträgt.

2. Halbleiterbauelement nach Anspruch 1, wobei der Winkel zwischen der Seite (7a) der Furche (7) und der ersten Fläche (3a) der kristallinen Oxid-Halbleiterschicht (3) 150° oder weniger beträgt.

3. Halbleiterbauelement nach Anspruch 1 oder 2, wobei die Breite der Furche (7) zum Boden (7b) der Furche (7) hin schmaler wird.

4. Halbleiterbauelement nach einem der Ansprüche 1 bis 3, wobei die Seite (7a) der Furche (7) verjüngt ist.

5. Halbleiterbauelement nach Anspruch 4, wobei der Winkel zwischen der Seite (7a) der Furche (7) und der ersten Fläche (3a) der kristallinen Oxid-Halbleiterschicht (3) in einem Bereich von mehr als 90° bis 135° oder weniger liegt.

6. Halbleiterbauelement nach einem der Ansprüche 1 bis 5, wobei die kristalline Oxid-Halbleiterschicht (3) zwei oder mehr Furchen (7) umfasst.

7. Halbleiterbauelement nach Anspruch 6,
wobei die kristalline Oxid-Halbleiterschicht (3) vier oder mehr Furchen (7) umfasst.

8. Halbleiterbauelement nach einem der Ansprüche 1 bis 7, wobei das Halbleiterbauelement (3) ein Leistungsbauelement (171) und/oder ein vertikales Halbleiterbauelement ist.

9. Halbleiterbauelement nach einem der Ansprüche 1 bis 8, wobei das Halbleiterbauelement eine Diode oder ein Transistor ist.

10. Halbleiterbauelement nach einem der Ansprüche 1 bis 9, wobei das Halbleiterbauelement eine Schottky-Diode (105a) mit Übergangsbarriere ist.

11. Halbleiterbauelement nach einem der Ansprüche 1 bis 10,
wobei die mindestens eine Elektrode (2, 4) eine erste Elektrode (2), die elektrisch mit der kristallinen Oxid-Halbleiterschicht (3) verbunden ist, und eine zweite Elektrode (4), die elektrisch mit der kristallinen Oxid-Halbleiterschicht (3) verbunden ist, umfasst, und
wobei die erste Elektrode (2) näher an der ersten Fläche (3a) der kristallinen Oxid-Halbleiterschicht (3) positioniert ist als die zweite Elektrode (4) und die zweite Elektrode (4) näher an einer zweiten Fläche (3b) der kristallinen Oxid-Halbleiterschicht (3) positioniert ist als die erste Elektrode (2), wobei die zweite Fläche (3b) der ersten Fläche (3a) gegenüberliegt.

12. System, umfassend:
ein Halbleiterbauelement nach einem der Ansprüche 1 bis 11.

## Revendications

1. Dispositif semi-conducteur, comprenant :
une couche semi-conductrice d'oxyde cristallin (3) ; et
au moins un électrode (2, 4) connectée électriquement à la couche semi-conductrice d'oxyde cristallin (3),
dans lequel la couche semi-conductrice d'oxyde cristallin (3) consiste en α-Ga₂O₃,
dans lequel la couche semi-conductrice d'oxyde cristallin (3) comprend au moins une tranchée (7) dans la couche semi-conductrice d'oxyde cristallin (3) sur un côté d'une première surface (3a) de la couche semi-conductrice d'oxyde cristallin (3),
dans lequel la tranchée (7) comprend un fond (7b), un côté (7a), et au moins une partie en arc (7c) positionnée entre le fond (7b) et le côté (7a) avec un radius de courbure qui est dans une plage de 100 nm à 500 nm,
dans lequel la tranchée (7) a une largeur inférieure ou égale à 2 µm, et
dans lequel un angle entre le côté (7a) de la tranchée (7) et la première surface (3a) de la couche semi-conductrice d'oxyde cristallin (3) est de 90° ou plus.

2. Dispositif semi-conducteur de la revendication 1, dans lequel l'angle entre le côté (7a) de la tranchée (7) et la première surface (3a) de la couche semi-conductrice d'oxyde cristallin (3) est de 150° ou moins.

3. Dispositif semi-conducteur de la revendication 1 ou 2, dans lequel la largeur de la tranchée (7) devient plus étroite vers le fond (7b) de la tranchée (7).

4. Dispositif semi-conducteur de l'une quelconque des revendications 1 à 3, dans lequel le côté (7a) de la tranchée (7) est effilé.

5. Dispositif semi-conducteur de la revendication 4, dans lequel l'angle entre le côté (7a) de la tranchée (7) et la première surface (3a) de la couche semi-conductrice d'oxyde cristallin (3) est compris dans une plage allant de plus de 90° à 135° ou moins.

6. Dispositif semi-conducteur de l'une des revendications 1 à 5, dans lequel la couche semi-conductrice d'oxyde cristallin (3) comprend deux tranchées (7) ou plus.

7. Dispositif semi-conducteur de la revendication 6,
dans lequel la couche semi-conductrice d'oxyde cristallin (3) comprend quatre tranchées (7) ou plus.

8. Dispositif semi-conducteur de l'une des revendications 1 à 7, dans lequel le dispositif semi-conducteur (3) est un dispositif d'alimentation (171) et/ou un dispositif semi-conducteur vertical.

9. Dispositif semi-conducteur de l'une des revendications 1 à 8, dans lequel le dispositif semi-conducteur est une diode ou un transistor.

10. Dispositif semi-conducteur de l'une des revendications 1 à 9, dans lequel le dispositif semi-conducteur est une diode Schottky à barrière de jonction (105a).

11. Dispositif semi-conducteur de l'une des revendications 1 à 10,
dans lequel l'au moins une électrode (2, 4) comprend une première électrode (2) connectée électriquement à la couche semi-conductrice d'oxyde cristallin (3) et une deuxième électrode (4) connectée électriquement à la couche semi-conductrice d'oxyde cristallin (3), et
dans lequel la première électrode (2) est positionnée plus près de la première surface (3a) de la couche semi-conductrice d'oxyde cristallin (3) que la deuxième électrode (4), et la deuxième électrode (4) est positionnée plus près d'une deuxième surface (3b) de la couche semi-conductrice d'oxyde cristallin (3) que la première électrode (2), la deuxième surface (3b) étant opposée à la première surface (3a).

12. Système comprenant :
un dispositif semi-conducteur de l'une des revendications 1 à 11.
